# EUROPÄISCHE PATENTSCHRIFT

(11) **EP 2 881 959 B1**
(45) Veröffentlichungstag und Bekanntmachung des Hinweises auf die Patenterteilung: **12.10.2016**
(21) Anmeldenummer: 14196256.3
(22) Anmeldetag: 04.12.2014
(51) Int. Cl.: H01H 9/04, H02B 1/044, H02B 1/28

(54) **Betätigungsvorrichtung für ein explosionsgeschütztes Gehäuse**
Actuation device for an explosion-proof housing
Dispositif d'actionnement pour un boîtier anti-déflagrant

(30) Priorität: 04.12.2013 DE 102013113429
(43) Veröffentlichungstag der Anmeldung: 10.06.2015
(73) Patentinhaber: R. Stahl Schaltgeräte GmbH, 74638 Waldenburg (DE)
(72) Erfinder: Kondrus, Elena, 74653 Künzelsau (DE)
(74) Vertreter: Rüger, Barthelt & Abel

(56) Entgegenhaltungen:
- EP-A2- 1 345 300
- CA-A1- 2 507 720
- DE-B- 1 033 310
- US-A- 4 563 549

## Beschreibung

Die Erfindung betrifft eine Betätigungsvorrichtung für ein explosionsgeschütztes Gehäuse sowie ein Gehäuse mit einer solchen Betätigungsvorrichtung. Das Gehäuse ist vorzugsweise in der Zündschutzart "druckfeste Kapselung (Exd)" ausgeführt.

Explosionsgeschützte Gehäuse dienen dazu, potenzielle Zündquellen, die zu einer Zündung einer explosionsgefährdeten Atmosphäre führen könnten, aufzunehmen und zu verhindern, dass zündfähige heiße Gase oder Zündfunken aus dem Inneren des Gehäuses in die explosionsgefährdete Atmosphäre gelangen. Problematisch bei solchen Gehäusen sind Durchführungen durch die Gehäusewand. An diesen Stellen muss sichergestellt werden, dass eine Zündung der explosionsgefährdeten Atmosphäre in der Umgebung des Gehäuses ausgeschlossen werden kann. Bei den explosionsgeschützten Gehäusen in der Zündschutzart "druckfeste Kapselung" können im Bereich der Durchführung beispielsweise zünddurchschlagsichere Spalte gebildet werden, die allerdings einen hohen Fertigungsaufwand erfordern, um die Anforderungen an den Explosionsschutz zu erfüllen, wie sie insbesondere in der Norm EN 60079-1 definiert sind.

Einen hohen technischen Aufwand erfordern vor allem Betätigungsvorrichtungen, bei denen außerhalb des Gehäuseinnenraums eine Betätigungseinheit angeordnet ist, beispielsweise ein Drehschalter, ein Drückschalter, ein Drücktaster oder dergleichen. Die Betätigungsbewegung durch eine Bedienperson muss von der Betätigungseinheit in den Gehäuseinnenraum zu einer Schalteinheit hin übertragen werden. Als Schalteinheit kann jede elektrische, elektromechanische oder mechanische Einheit angesehen werden, bei der ein Schaltelement entsprechend der Betätigung bzw. Schaltstellung an der Betätigungseinheit bewegt werden soll. Die Betätigungsvorrichtung muss explosionsgeschützt durch die Wand des Gehäuses geführt werden und darf selbst nicht als Zündquelle für die explosionsgeschützte Atmosphäre dienen. Daher ist ein großer Aufwand sowie eine Prüfung und Zertifizierung der Betätigungsvorrichtung erforderlich, um diese in explosionsgeschützten Umgebungen verwenden und in explosionsgeschützte Gehäuse einbauen zu dürfen.

US 5 577 603 A beschreibt ein explosionsgeschütztes Gehäuse mit einem schwenkbar gelagerten Deckel. Durch den schwenkbaren Deckel ist eine Welle geführt. Am äußeren Ende der Welle sitzt eine Betätigungseinheit und am inneren Ende der Welle ist ein gabelförmig geschlitztes Kupplungsstück angeordnet. Der Schlitz im Kupplungsstück dient dazu, einen Kippschalter einer Schalteinheit, die im Gehäuseinnenraum angeordnet ist, formschlüssig zu umgreifen. Der Schlitz des Kupplungsstückes ist exzentrisch zur Drehachse der Welle angeordnet, die den Deckel des Gehäuses durchsetzt. Beim Drehen der Betätigungseinheit außerhalb des Gehäuses, wird der Schlitz des Kupplungsstücks geschwenkt und kann dadurch ein Umschalten des Kippschalters bewirken. Somit wird eine Drehbewegung der Betätigungseinheit über die die Gehäusewand durchsetzende Welle nach innen auf ein Kupplungsstück übertragen und kann zu einer Kippbewegung eines Kippschalters verwendet werden.

WO 2008/113429 A1 beschreibt ein explosionsgeschütztes Gehäuse mit einer trennbaren Schalterwelle. In einer Gehäusewand ist eine Buchse eingesetzt. Die Buchse hat einen Durchgangskanal, durch die eine Welle hindurchgeführt wird. Im Gehäuseinnenraum wird die Welle über eine Kupplung mit einer Schalteinheit gekoppelt. Über die Betätigungseinheit außerhalb des Gehäuseinnenraums kann die Welle gedreht und damit die Schalteinheit betätigt werden.

Die Anordnungen können nur Drehbewegungen übertragen.

US 4 563 549 offenbart eine Betätigungsvorrichtung für ein explosionsgeschütztes Gehäus, aufweisend eine Betätigungseinheit, eine Schalteinheit und eine Adaptereinrichtung. Die Betätigungseinheit hat einen ersten Träger relativ zu dem ein Betätigungselement bewegbar angeordnet ist. Die Schalteinheit hat einen zweiten Träger relativ zu dem ein Schaltelement bewegbar angeordnet ist. Die Adaptereinrichtung weist einen Adapterkörper auf, der sich in Axialrichtung erstreckt, und der an einem axialen Ende einen ersten Befestigungsabschnitt und am anderen axialen Ende einen zweiten Befestigungsabschnitt aufweist. Die Adaptereinrichtung hat einen Adapterstößel, der im Adapterkörper in einem in einer Axialrichtung verlaufenden Adapterkanal verschiebbar gelagert ist, wobei zumindest in einem Axialabschnitt ein zünddurchschlagsicherer Spalt zwischen dem Adapterstößel und dem Adapterkanal gebildet ist. Das axiale erste Ende des Adapterstößels ist dem wenigstens einen Betätigungselement und das axiale zweite Ende des Adapterstößels ist dem Schaltelement zugeordnet.

Es kann als eine Aufgabe der vorliegenden Erfindung angesehen werden, eine Betätigungsvorrichtung zu schaffen, die eine hohe Flexibilität aufweist und eine kostengünstige Realisierung ermöglicht.

Diese Aufgabe wird durch eine Betätigungsvorrichtung mit den Merkmalen des Patentanspruches 1 sowie durch ein Gehäuse mit einer solchen Betätigungsvorrichtung gemäß den Merkmalen des Patentanspruches 13 gelöst.

Die Betätigungsvorrichtung für das explosionsgeschützte Gehäuse weist eine mechanische Betätigungseinheit mit einem ersten Träger auf. An dem ersten Träger ist ein Betätigungselement in Axialrichtung relativ zum ersten Träger bewegbar gelagert. Das Betätigungselement kann durch einen Drückschalter oder einen Drücktaster in Axialrichtung bewegt werden. Alternativ hierzu ist es auch möglich, dass die Betätigungseinheit einen Drehschalter aufweist. Dessen Drehbewegung kann durch ein Getriebe in eine axiale Bewegung übersetzt werden. Als Getriebe kann beispielsweise ein Nocken, eine Keilflächenanordnung oder dergleichen dienen. Durch eine gegenüber der Axialrichtung sowie in Drehrichtung geneigte Schrägfläche kann eine axiale Bewegung des Betätigungselements erzeugt werden.

Die Betätigungsvorrichtung weist außerdem eine Schalteinheit auf. Die Schalteinheit hat einen zweiten Träger, an dem wenigstens ein in Axialrichtung bewegbares Schaltelement angeordnet ist. Die Schalteinheit befindet sich in der Einbaulage in einem explosionsgeschützten Gehäuse im Gehäuseinnenraum. Bei der Schalteinheit kann es sich beispielsweise um einen elektrischen bzw. elektromechanischen Schalter handeln, der als Zündquelle dienen kann und deshalb durch das Gehäuse aufgenommen ist. Die Betätigungseinheit befindet sich in montierter Gebrauchslage außerhalb des Gehäuseinnenraums.

Die Betätigungsvorrichtung weist außerdem eine Adaptereinrichtung mit einem Adapterkörper auf. Der Adapterkörper erstreckt sich in Axialrichtung, wobei er in montierter Gebrauchslage die Gehäusewand durchsetzt. Der Adapterkörper hat an seinem einen Axialende einen ersten Befestigungsabschnitt und am gegenüberliegenden anderen Axialende einen zweiten Befestigungsabschnitt. In dem Adapterkörper verläuft in Axialrichtung wenigstens ein Adapterkanal, wobei in jedem Adapterkanal ein Adapterstößel in Axialrichtung verschiebbar gelagert ist. Die Anzahl der Adapterstößel entspricht der Anzahl der zu betätigenden Schaltelemente oder Schaltstellungen der Schalteinheit. Es können ein, zwei oder auch mehr Schaltelemente bzw. Schaltstellungen und entsprechend viele Adapterstößel vorhanden sein. Sind zwei oder mehr Adapterstößel vorhanden, erstrecken sich die Adapterkanäle parallel zueinander und insbesondere mit Abstand zu einer in Axialrichtung verlaufenden Längsachse durch den Adapterkörper. Zumindest in einem Axialabschnitt ist zwischen jedem Adapterstößel und dem zugeordneten Adapterkanal ein zünddurchschlagsicherer Spalt gebildet. Dadurch ist sichergestellt, dass aus dem Gehäuseinnenraum durch den wenigstens einen Adapterkanal keine Zündung einer explosionsgefährdeten Atmosphäre erfolgen kann.

Bei einer bevorzugten Ausführungsform ist der wenigstens eine Adapterstößel über ein Vorspannmittel, beispielsweise eine Feder, insbesondere eine Schraubenfeder, in eine Ausgangslage zur Betätigungseinheit bzw. zum Betätigungselement hin vorgespannt. Durch das Betätigungselement kann der Adapterstößel aus seiner Ausgangslage heraus axial bewegt bzw. verschoben werden. Eine Drehbewegung des Adapterstößels um seine Längsachse bzw. um die Axialrichtung wird durch das wenigstens eine Betätigungselement nicht hervorgerufen. Jeder Adapterstößel hat ein erstes axiales Ende, das dem wenigstens einen Betätigungselement zugeordnet ist. Das entgegengesetzte axiale zweite Ende jedes Adapterstößels ist einem betreffenden Schaltelement der Schalteinheit zugeordnet. Zwischen dem wenigstens einem Adapterstößel und dem Betätigungselement am ersten Ende sowie zwischen dem Adapterstößel und dem Schaltelement am zweiten Ende werden jeweils vorzugsweise ausschließlich in Axialrichtung wirkende Druckkräfte übertragen. Hierfür kann der Adapterstößel beispielsweise am ersten Ende eine erste Stößelfläche und an seinem zweiten Ende eine zweite Stößelfläche aufweisen. An der ersten Stößelfläche liegt der Adapterstößel ohne formschlüssige Verbindung lose am zugeordneten Betätigungselement an. Umgekehrt kann der Adapterstößel an der zweiten Stößelfläche lose ohne formschlüssige Verbindung am zugeordneten Schaltelement der Schalteinheit anliegen. Der wenigstens eine Adapterstößel erstreckt sich bevorzugt gerade entlang einer Achse.

Der erste Träger der Betätigungseinheit ist lösbar mit dem ersten Befestigungsabschnitt verbunden und der zweite Träger der Schalteinheit ist lösbar mit dem zweiten Betätigungsabschnitt der Adaptereinrichtung verbunden. Somit dient der Adapterkörper gleichzeitig als Träger für die Betätigungseinheit und die Schalteinheit. Es wird eine Baueinheit geschaffen. Der erste Träger und der zweite Träger sind dabei unbeweglich am Adapterkörper angeordnet.

Im Anschluss an den wenigstens einen Adapterstößel kann im Bereich des ersten Befestigungsabschnitts das Getriebe zur Umsetzung einer Drehbewegung eines Betätigungselements in eine axiale Bewegung angeordnet sein. Das Getriebe kann als optionale Baueinheit zu der Adaptereinrichtung gehören oder Bestandteil der Betätigungseinheit sein.

Die beiden Befestigungsabschnitte am Adapterkörper, zwischen denen sich der wenigstens eine Adapterstößel erstreckt, dienen mithin als Befestigungsschnittstellen für die Betätigungseinheit mit oder ohne Getriebe einerseits und für die Schalteinheit andererseits. Lediglich die Adaptereinrichtung muss die besonderen Anforderungen an eine zünddurchschlagsichere Ausführung erfüllen und entsprechend geprüft bzw. zertifiziert werden. Als Betätigungseinheit und als Schalteinheit können Standardbaueinheiten verwendet werden. Dies hat den Vorteil, dass das Verwenden von unterschiedlichen Betätigungseinheiten und/oder Schalteinheiten für unterschiedliche Anwendungen in Kombination mit stets derselben geprüften Adaptereinrichtung möglich ist. Eine Explosionsschutzprüfung oder Zertifizierung der gesamten Betätigungsvorrichtung für jeden Anwendungsfall kann daher entfallen. Es ist ausreichend, wenn die verwendete Adaptereinrichtung einmal auf die Erfüllung der Anforderungen geprüft wird. Für die unterschiedlichen Anwendungsfälle können dann Standardkomponenten an der Adaptereinrichtung angebracht werden, was den Aufwand und die Kosten erheblich senkt.

Dadurch, dass die Betätigungseinheit, die Adaptereinrichtung und die Schalteinheit unmittelbar lösbar aneinander angeordnet sind, ist stets eine sichere Bedienung der Schalteinheit über die Betätigungseinheit gewährleistet. Auch beim Ausüben von axialen Zugkräften auf die Betätigungseinheit kann es nicht dazu kommen, dass der wenigstens eine Adapterstößel sich derart vom zugeordneten Schaltelement entfernt, dass eine sichere Betätigung des Schaltelements über die Betätigungseinheit nicht mehr gewährleistet ist.

Bei einem Ausführungsbeispiel weist die Adaptereinrichtung eine erste Befestigungseinrichtung auf, mittels der der erste Befestigungsabschnitt des Adapterkörpers mit der Betätigungseinheit lösbar verbunden ist. Zusätzlich oder alternativ kann die Adaptereinrichtung eine zweite Befestigungseinrichtung aufweisen, mittels der der zweite Befestigungsabschnitt des Adapterkörpers mit der Schalteinheit lösbar verbunden ist. Über die erste und/oder zweite Befestigungseinrichtung wird vorzugsweise eine formschlüssige und/oder eine kraftschlüssige Verbindung hergestellt, beispielsweise eine Schraubverbindung und/oder Rastverbindung.

Bei einem vorteilhaften Ausführungsbeispiel weist die erste Befestigungseinrichtung ein an der Betätigungseinheit angeordnetes bzw. gehaltenes Verbindungsteil auf. Das Verbindungsteil wird zur Herstellung der lösbaren Verbindung formschlüssig und/oder kraftschlüssig mit dem ersten Befestigungsabschnitt des Adapterkörpers verbunden. Beispielsweise kann das Verbindungsteil ein Gewinde aufweisen, das in ein entsprechendes Gegengewinde am ersten Befestigungsabschnitt eingreift. Bei einem Ausführungsbeispiel ist das Verbindungsteil mit einem Innengewinde ausgeführt, das mit einem Außengewinde am ersten Befestigungsabschnitt lösbar verbindbar ist. Das Verbindungsteil stellt sozusagen eine Überwurfmutter dar.

Bei einem Ausführungsbeispiel kann der erste Befestigungsabschnitt hohlzylindrisch ausgeführt sein.

Das Verbindungsteil kann durch ein Halteteil lösbar an der Betätigungseinheit gehalten sein. Das Halteteil kann beispielsweise formschlüssig und/oder kraftschlüssig in eine Aussparung an der Betätigungseinheit eingreifen und als Anschlag bzw. als Verliersicherung für das Verbindungsteil dienen. Das Anordnen des Halteteils und mithin des Verbindungsteils an der Betätigungseinheit erfolgt vorzugsweise werkzeuglos.

Das Halteteil kann zumindest an einer Stelle mit dem ersten Befestigungsabschnitt des Adapterkörpers in Kontakt stehen. Dadurch können das Halteteil und der erste Befestigungsabschnitt gemeinsam ein Drehlagenvorgabemittel bilden. Über das Drehlagenvorgabemittel kann die Relativdrehlage um die Axialrichtung bzw. um die Längsachse des Adapterkörpers zwischen der Betätigungseinheit und/oder dem Betätigungselement und/oder dem ersten Träger einerseits und dem Adapterkörper andererseits vorgeben werden. Dadurch ist sichergestellt, dass eine gewünschte Zuordnung des Betätigungselements zum wenigstens einen Adapterstößel sichergestellt ist und die Betätigung des Betätigungselements über den Adapterstößel auf das zugeordnete Schaltelement sicher erfolgt.

Der Adapterkörper kann bei einer Ausführungsform außerdem einen Mittelabschnitt mit einer vorzugsweise zylindrischen Außenkontur aufweisen. An bzw. in diesem Mittelabschnitt ist der wenigstens eine Adapterstößel gelagert bzw. der wenigstens eine Adapterkanal vorhanden.

Vorzugsweise weist die Betätigungseinheit keinerlei elektrischen oder elektronischen Komponenten auf, sondern besteht lediglich aus mechanischen Elementen, die nicht als Zündquelle dienen können. Da die Schalteinheit innerhalb des explosionsgeschützten Gehäuses angeordnet ist, müssen an die Schalteinheit keine Anforderungen im Bezug auf den Explosionsschutz gestellt werden. Wenn die Betätigungseinheit Komponenten aufweist, die als Zündquelle dienen könnten ist es vorteilhaft, wenn die Betätigungseinheit in der Zündschutzart "erhöhte Sicherheit" ausgeführt ist.

In Gebrauchslage durchsetzt der Adapterkörper eine vorzugsweise im Wesentlichen zylindrische Öffnung in der Gehäusewand. Zwischen der Gehäusewand und dem Adapterkörper ist dabei ein zünddurchschlagsicherer Spalt gebildet. Dieser zünddurchschlagsichere Spalt kann als unprofilierter zylindrischer Spalt, als profilierter Spalt oder als Gewindespalt mit einem explosionsgeschützten Gewinde ausgeführt sein.

Vorteilhafte Ausgestaltungen der Erfindung ergeben sich aus den abhängigen Patentansprüche, der Beschreibung und der Zeichnung. Nachfolgend werden bevorzugte Ausführungsbeispiele anhand der beigefügten Zeichnung im Einzelnen erläutert. Es zeigen:
Figur 1 eine stark vereinfachte, schematische Darstellung eines Gehäuses in einem Schnitt mit einer Betätigungsovorrichtung,
Figur 2 ein vereinfachtes Schaltbild zur Darstellung der Funktionsweise eines Ausführungsbeispiels der Betätigungsvorrichtung,
Figur 3 ein vereinfachtes Schaltbild zur Darstellung der Funktionsweise eines weiteren Ausführungsbeispiels der Betätigungsvorrichtung,
Figur 4 ein Ausführungsbeispiel der Betätigungsvorrichtung in perspektivischer Explosionsdarstellung,
Figur 5 das Ausführungsbeispiel der Betätigungsvorrichtung aus Figur 4 in perspektivischer Ansicht,
Figur 6 eine Adaptereinrichtung der Betätigungsvorrichtung gemäß dem Ausführungsbeispiel der Figuren 4 und 5 in einem Schnittbild und
Figur 7 die Adaptereinrichtung gemäß Figur 6 in einer perspektivischen Ansicht.

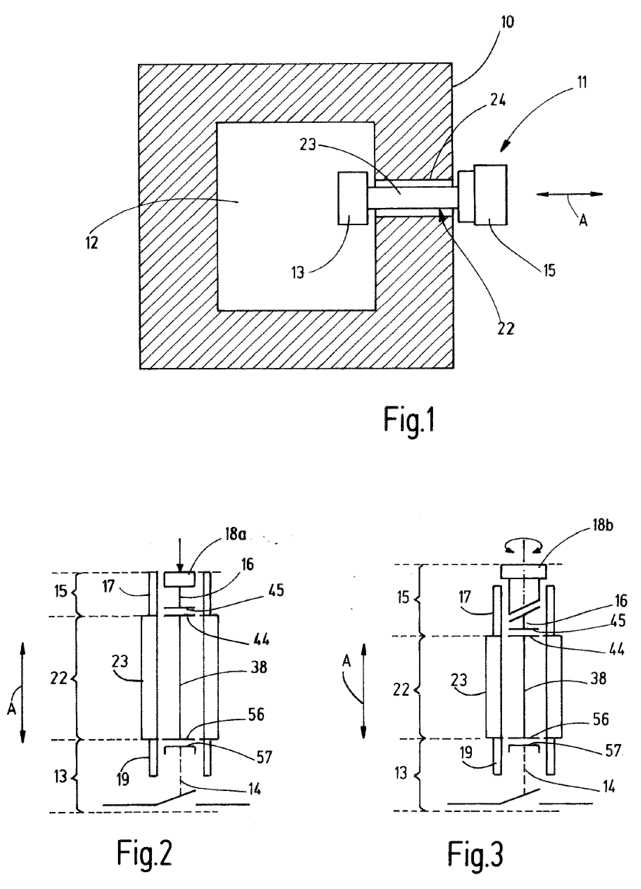

In Figur 1 ist ein explosionsgeschütztes Gehäuse 10 mit einer Betätigungsvorrichtung 11 stark schematisiert veranschaulicht. Das Gehäuse 10 dient dazu, elektrische und/oder elektronische Betriebsmittel im Gehäuseinnenraum 12 aufzunehmen, die als potenzielle Zündquelle für eine explosionsgefährdete Atmosphäre außerhalb des Gehäuses 10 dienen könnten. Das Gehäuse 10 ist beim Ausführungsbeispiel in der Zündschutzart "druckfeste Kapselung" (Ex-d) ausgeführt.

Die Betätigungsvorrichtung 11 weist eine im Innenraum 12 angeordnete Schalteinheit 13 auf. Die Schalteinheit 13 kann ein oder mehrere mechanisch zu betätigende Schaltelemente 14 (Figuren 2, 3 und 4) aufweisen. Über das Schaltelement 14 kann ein elektrischer Kontakt geöffnet und/oder geschlossen werden. Die Schalteinheit 13 ist nicht explosionsgeschützt ausgeführt und deshalb als elektrisches und/oder elektronisches Betriebsmittel im Innenraum 12 des Gehäuses 10 angeordnet. Das wenigstens eine Schaltelement 14 ist in Axialrichtung A bewegbar an einem zweiten Träger 19 der Schalteinheit 13 gelagert.

Zur Betätigungsvorrichtung 11 gehört außerdem eine Betätigungseinheit 15, die außerhalb des Gehäuses 10 und somit außerhalb des Innenraums 12 in der explosionsgefährdeten Atmosphäre angeordnet ist. Die Betätigungseinheit 15 weist ein Betätigungselement 16 auf, das in einer Axialrichtung A bewegbar an einem ersten Träger 17 angeordnet ist. Die axiale Bewegung oder Verschiebung des Betätigungselements 16 erfolgt durch manuelles Betätigen eines Druckschalters oder Drucktasters 18a oder eines Drehschalters oder Drehtasters 18b der Betätigungseinheit 15. Durch das Drücken oder Drehen des betreffenden Schalters oder Tasters 18a, 18b wird das Betätigungselement 16 in Axialrichtung zumindest zwischen zwei Position bewegt. Die Drehbewegung eines Drehschalters oder eines Drehtasters 18b kann über ein Getriebe, beispielsweise mittels Nocken und/oder Schrägflächen, in eine axiale Bewegung des Betätigungselements 16 umgesetzt werden, was in Figur 3 stark schematisiert veranschaulicht ist. Das Getriebe ist hier als Teil der Betätigungseinheit 15 dargestellt. Alternativ könnte ein solches Getriebe auch als optionale Baueinheit zu einer Adaptereinrichtung 22 der Betätigungsvorrichtung 11 gehören.

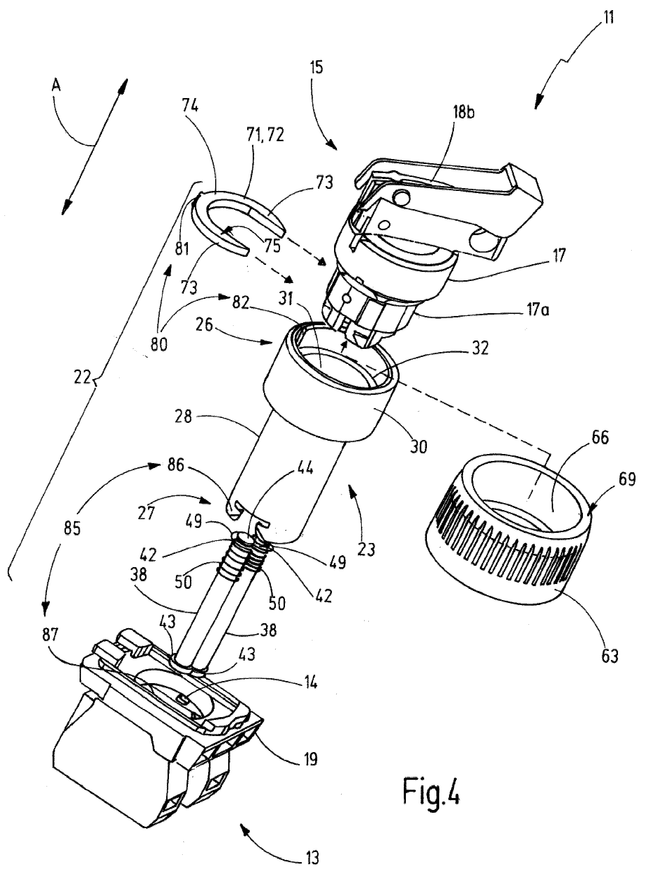

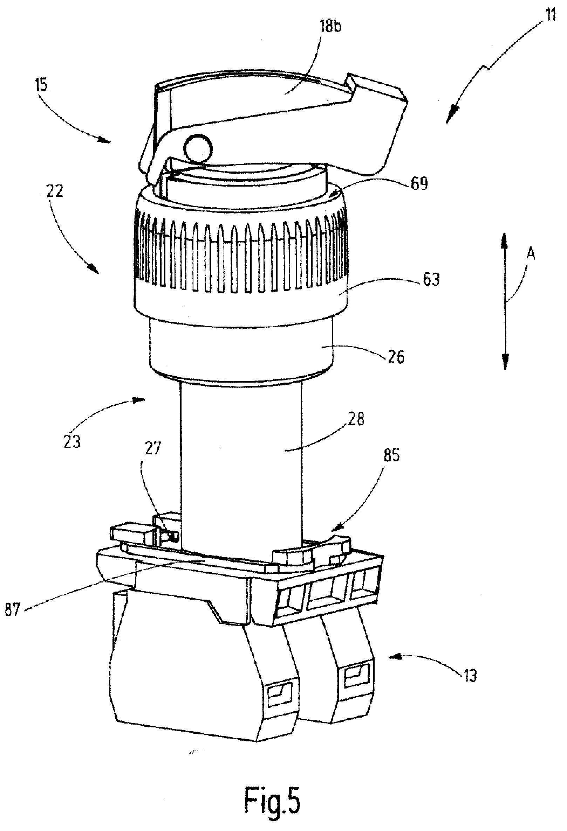

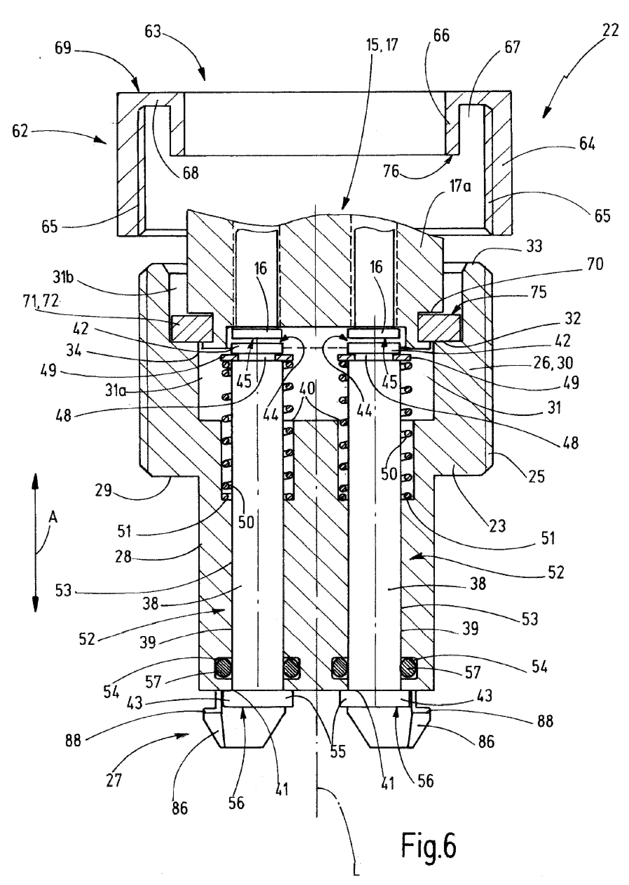

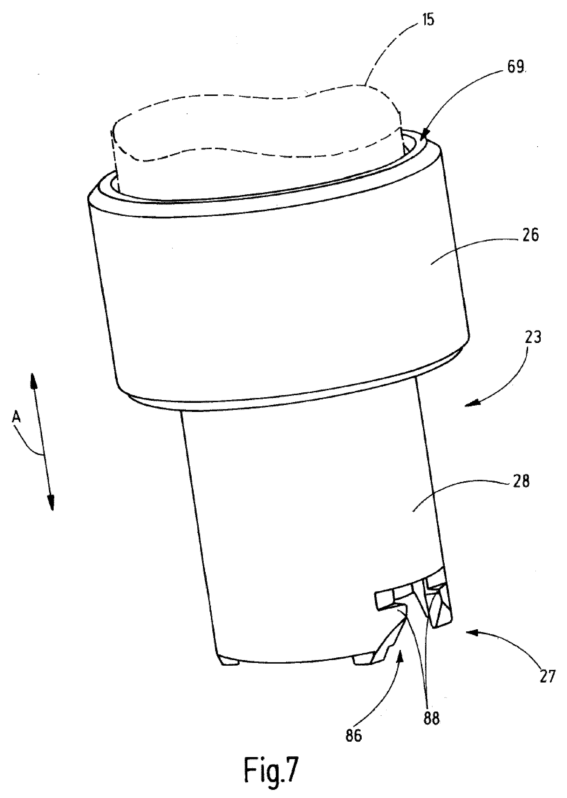

Die Adaptereinrichtung 22 verbindet die Betätigungseinheit 15 mit der Schalteinheit 13. Dabei durchsetzt ein Adapterkörper 23 der Adaptereinrichtung 22 eine Gehäuseöffnung 24 im Gehäuse 10. Die Anordnung des Adapterkörpers 23 in der Gehäuseöffnung 24 erfolgt explosionsgeschützt, beispielsweise durch Bildung eines explosionsgeschützten Spalts. Beim bevorzugten Ausführungsbeispiel weist der Adapterkörper 23 ein Außengewinde 25 auf (Figur 6), mit dem er in ein entsprechendes Innengewinde im Bereich der Gehäuseöffnung 24 explosionsgeschützt eingeschraubt werden kann. Es wird an dieser Stelle darauf hingewiesen, dass das Außengewinde 25 in den Figuren 4, 5 und 7 zur Vereinfachung der Darstellung nicht gezeigt ist, obwohl es beim Ausführungsbeispiel vorzugsweise vorhanden ist.

Der Adapterkörper 23 ist beim Ausführungsbeispiel zumindest abschnittsweise zylindrisch konturiert. Der Adapterkörper hat einen ersten Befestigungsabschnitt 26 und an dem entgegengesetzten axialen Ende einen zweiten Befestigungsabschnitt 27. Die beiden Befestigungsabschnitte 26, 27 sind durch einen mittleren Abschnitt miteinander verbunden, der als Mittelabschnitt 28 bezeichnet ist. Der Adapterkörper 23 ist insgesamt vorzugsweise aus einem einheitlichen Material ohne Naht- und Fügestelle einstückig hergestellt.

Der erste Befestigungsabschnitt 26 ist beispielsgemäß hohlzylindrisch ausgeführt. Er weist eine zylindrische Außenfläche auf, in der beim Ausführungsbeispiel das Außengewinde 25 eingebracht ist. Der Durchmesser des ersten Befestigungsabschnitts 26 ist größer als der des sich anschließenden Mittelabschnitts 28. An der Außenfläche des Adapterkörpers 23 ist zwischen dem ersten Befestigungsabschnitt 26 und dem Mittelabschnitt 28 eine Ringstufe 29 oder alternativ ein anderer Übergang gebildet.

Der hohlzylindrische erste Befestigungsabschnitt 26 ist durch eine Hohlzylinderwand 30 des Adapterkörpers 23 gebildet. Die Hohlzylinderwand 30 erstreckt sich ausgehend vom Mittelabschnitt 28 koaxial zu einer Längsachse L des Adapterkörpers 23. Das Außengewinde 25 kann die zylindrische Mantelfläche der Hohlzylinderwand 30 in Axialrichtung A vollständig abdecken. Die Hohlzylinderwand 30 umschließt einen Aufnahmeraum 31 in Umfangsrichtung um die Längsachse L. In den Aufnahmeraum 31 ragt wenigstens ein Anschlag 32 hinein. Der Anschlag 32 ist beim Ausführungsbeispiel durch eine Ringfläche um die Längsachse L gebildet. Alternativ hierzu könnten auch drei oder mehr in Umfangsrichtung zueinander beabstandete Anschläge 32 vorhanden sein. Die Anschlagfläche bzw. die Ringfläche des Anschlags 32 ist beim Ausführungsbeispiel rechtwinklig zur Längsachse L ausgerichtet. Die Anschlagfläche des Anschlags 32 weist zu einem freien Ende 33 der Hohlzylinderwand 30 hin, dass sich auf der dem Mittelabschnitt 28 entgegengesetzten Seite des ersten Befestigungsabschnitts 26 befindet.

Der Anschlag 32 ist beispielsgemäß durch einen dem Innendurchmesser des Aufnahmeraums 31 verringernden Ringvorsprung 34 gebildet. Dadurch hat der Aufnahmeraum 31 zwei zylindrische Abschnitte, einen inneren Abschnitt 31a innerhalb des Ringvorsprungs 34 und einen sich an den inneren Abschnitt 31a anschließenden äußeren Abschnitt 31b. Der äußere Abschnitt 31b befindet sich axial zwischen dem Anschlag 32 und dem freien Ende 33 und weist beispielsgemäß einen größeren Durchmesser auf, als der innere Abschnitt 31a.

Die Adaptereinrichtung 22 weist wenigstens einen Adapterstößel 38 auf. Die Anzahl der Adapterstößel 38 richtet sich danach, wie viele Schaltelemente 14 der Schalteinheit 14 zu betätigen sind oder wie viele Schaltstellungen die Schalteinheit 14 hat. Die Anzahl der Adapterstößel 38 kann alternativ oder zusätzlich von der Anzahl der Betätigungselemente 16 der Betätigungseinheit 15 abhängen. Allerdings ist es auch möglich, mehrere Betätigungselemente 16 und/oder mehrere Schaltelemente 14 einem Adapterstößel 38 zuzuordnen, beispielsweise wenn verschiedene Schaltstellung des Schalters oder Tasters 18a, 18b dieselbe Funktion haben und unter Vermittlung der Adaptereinrichtung 22 auf dasselbe Schaltelement 14 einwirken sollen. Während in den schematischen Darstellungen gemäß der Figuren 2 und 3 jeweils ein Betätigungselement 16, ein Adapterstößel 38 und ein Schaltelement 14 dargestellt sind, weist das bevorzugte Ausführungsbeispiel gemäß der Figuren 4 bis 7 zwei separate Adapterstößel 38 auf. In Abwandlung hierzu könnten auch mehr oder weniger als zwei Adapterstößel 38 vorhanden sein.

Die beiden Adapterstößel 38 sind jeweils in einem Adapterkanal 39 in Axialrichtung A verschiebbar gelagert. Die Adapterkanäle 39 durchsetzen den Adapterkörper 23 in Axialrichtung A vollständig, so dass sie auf beiden Seiten jeweils eine Mündung aufweisen. Beispielsgemäß befindet sich die erste Mündung 40 jedes Adapterkanals im Aufnahmeraum 31 und bei dem hier beschriebenen Ausführungsbeispiel im inneren Abschnitt 31a. Die zweite Mündung 41 jedes Adapterkanals 39 befindet sich im Übergangsbereich zwischen dem Mittelabschnitt 28 und dem zweiten Befestigungsabschnitt 27.

Jeder Adapterstößel 38 hat ein axiales erstes Ende 42 und auf der entgegengesetzten Axialseite ein zweites Ende 43. An seinem ersten Ende 42 hat jeder Adapterstößel 38 eine erste Stößelfläche 44, die einem Betätigungselement 16 zugeordnet ist. Beispielsgemäß liegt die erste Stößelfläche 44 einer Betätigungsfläche 45 des Betätigungselements 16 gegenüber. Die erste Stößelfläche 44 kann in jeder Axialposition des Betätigungselements 16 an der Betätigungsfläche 45 anliegen oder in der Ruhelage des Adapterstößels 38 (Figur 6) mit geringem Schaltabstand der zugeordneten Betätigungsfläche 45 gegenüberliegen. Die erste Stößelfläche 44 und/oder die Betätigungsfläche 45 sind beim Ausführungsbeispiel rechtwinklig zur Axialrichtung A ausgerichtet. Die erste Stößelfläche 44 und/oder die Betätigungsfläche 45 sind beispielsgemäß eben ausgeführt, könnten aber auch eine andere zueinander komplementäre Gestalt haben. Eine Verbindung zwischen der ersten Stößelfläche 44 und der Betätigungsfläche 45 zur Übertragung von axialen Zugkräften besteht nicht. Die beiden Flächen 44, 45 liegen verbindungsfrei aneinander an.

Im Bereich des ersten Endes 42 mit Abstand zur ersten Stößelfläche 44 weist jeder Adapterstößel 38 eine radial nach außen offene Ringnut 48 auf, in der ein Sicherungsring 49 angeordnet ist. Der Sicherungsring 49 ragt radial nach außen vom Adapterstößel 38 weg und bildet somit eine Abstützfläche für eine Feder und beispielsgemäß eine Schraubenfeder 50. Die Schraubenfeder 50 stützt sich an ihrem entgegengesetzten Ende an einer Ringschulter 51 im zugeordneten Adapterkanal 39 ab. Die Ringschulter 51 ist im Adapterkanal 39 dadurch gebildet, dass dieser im Anschluss an di erste Mündung 40 einen größeren Durchmesser aufweiset und sich durch die Ringschulter 51 auf einen anderen, kleineren Durchmesser verringert. Dieser kleinere Durchmesser des Adapterkanals 39 entspricht im Wesentlichen dem Außendurchmesser des zylindrischen Schafts des Adapterstößels 38. Der Adapterstößel 38 ist durch die Feder 50 mit einer Vorspannkraft zum zugeordneten Betätigungselement 16 hin in seine Ruhelage vorgespannt.

Am axialen zweiten Ende 43 weist jeder Adapterstößel 38 ein Endstück 55 auf. Das Endstück 55 hat vorzugsweise einen größeren Durchmesser als der übrige Teil des Adapterstößels 38, so dass es nicht in den zugeordneten Adapterkanal 39 eingeführt werden kann. Das Endstück 55 liegt in der Ruhelage des betreffenden Adapterstößels 38 am Randbereich um die zweite Mündung 41 des Adapterkörpers 23 an. Beispielsgemäß hat das Endstück 55 eine zylindrische Gestalt. An dem Endstück 55 ist eine zweite Stößelfläche 56 vorhanden, die beim Ausführungsbeispiel als ebene Stößelfläche 56 ausgeführt ist. Die zweite Stößelfläche 56 ist beispielsgemäß rechtwinklig zur Axialrichtung A ausgerichtet.

Die zweite Stößelfläche 56 ist dem jeweils zugeordneten Schaltelement 14 der Schalteinheit 13 zugewandt. Das Schaltelement 14 weist eine der zweiten Stößelfläche 56 gegenüberliegende Schalterfläche 57 auf. In der Ruhelage des Adapterstößels 38 kann die zweite Stößelfläche 56 an der zugeordneten Schalterfläche 57 anliegen oder einen geringen axialen Schaltabstand dazu aufweisen. Die zweite Stößelfläche 56 und/oder die Schalterfläche 57 sind beispielsgemäß eben ausgeführt, könnten aber auch eine andere zueinander komplementäre Gestalt haben. Eine Verbindung zwischen der zweiten Stößelfläche 56 und der Schalterfläche 57 zur Übertragung von axialen Zugkräften besteht nicht. Die beiden Flächen 56, 57 liegen verbindungsfrei aneinander an.

In einem Axialabschnitt 52 ist zwischen der Mantelfläche des betreffenden Adapterstößels 38 und der Kanalwand des Adapterkanals 39 ein zünddurchschlagsicherer Spalt 53 gebildet. Beim Ausführungsbeispiel entspricht die Länge des zünddurchschlagsicheren Spalts 53 dem axialen Abstand zwischen der Ringschulter 51 und der zweiten Mündung 41 im betreffenden Adapterkanal 39. Um zu vermeiden, dass durch den zünddurchschlagsicheren Spalt 53 Flüssigkeiten, Staubpartikel oder dergleichen in den Innenraum 12 des Gehäuses 10 gelangen, kann in einer ringförmigen Dichtungsnut 54 eine Dichtung 57, beispielsweise ein O-Ring angeordnet sein. Die Dichtungsnut 54 ist koaxial zur Längsachse des Adapterkanals 39 angeordnet und zu diesem hin offen. Somit kann die Dichtung 57 an der Außenfläche bzw. Mantelfläche des zugeordneten Adapterstößels 38 anliegen. Die axiale Position der Dichtung 57 bzw. der Dichtungsnut 54 ist grundsätzlich beliebig wählbar. Vorzugsweise befindet sich die Dichtung nahe an der zweiten Mündung 41 des Adapterkanals 39, so dass die Dichtung 57 sehr einfach in die zugeordnete Dichtungsnut 54 eingelegt werden kann.

Die Adaptereinrichtung 22 weist außerdem eine erste Befestigungseinrichtung 62 auf, die dazu eingerichtet ist, eine lösbare Verbindung zwischen dem Träger 17 der Betätigungseinheit 15 und dem Adapterkörper 23 herzustellen. Die erste Befestigungseinrichtung 62 weist hierfür ein Verbindungsteil 63 auf, das beim Ausführungsbeispiel lösbar an dem ersten Träger 17 gehalten ist. Über das Verbindungsteil 63 kann eine formschlüssige und/oder kraftschlüssige Verbindung zwischen der Betätigungseinheit 15 und dem Adapterkörper 23 hergestellt werden.

Das Verbindungsteil 63 ist beispielsgemäß als hohlzylindrisches Teil ausgeführt und weist einen Innendurchmesser auf, der zumindest so groß ist wie der Außendurchmesser des ersten Befestigungsabschnitts 26 bzw. der Hohlzylinderwand 30 des Adapterkörpers 23. Bei hergestellter Verbindung zwischen dem Verbindungsteil 63 und dem Adapterkörper 23 umschließt zumindest ein Abschnitt des Verbindungsteils 63 den ersten Befestigungsabschnitt 26 in Umfangsrichtung um die Längsachse L des Adapterkörpers 23 vollständig. Beispielsgemäß hat das Verbindungsteil 63 eine ringförmige Außenwand 64, die zumindest in einem axialen Bereich ein Innengewinde 65 aufweist. Das Innengewinde 65 kann auf das Außengewinde 25 am ersten Befestigungsabschnitt 26 des Adapterkörpers 23 aufgeschraubt werden. Die Verbindung zwischen dem Innengewinde 65 und dem Außengewinde 25 muss nicht als explosionsgeschützte Gewindeverbindung ausgeführt sein. Wenn das Außengewinde 25 am Adapterkörper 23 gleichzeitig dazu verwendet wird, den Adapterkörper 23 in ein Gewinde an der Gehäuseöffnung 24 einzuschrauben und dort eine explosionsgeschützte Gewindeverbindung herzustellen, muss es dennoch die entsprechenden Toleranzen und Dimensionen einhalten. Es ist in Abwandlung zum Ausführungsbeispiel auch möglich, am Adapterkörper 23 separate Außengewinde vorzusehen, wobei ein Außengewinde zur explosionsgeschützten Gewindeverbindung mit dem Gehäuse 10 und das andere Außengewinde zur lösbaren Verbindung mit dem Verbindungsteil 63 dient. Es ist auch möglich, den Adapterkörper auf andere Weise in der Gehäuseöffnung 24 zu befestigen als über eine Gewindeverbindung.

Auf einer Axialseite weist das Verbindungsteil 63 einen Innenring 66 auf, der einen kleineren Außendurchmesser aufweist als der Innendurchmesser der Außenwand 64 und koaxial zur Außenwand 64 angeordnet ist. Dadurch ist zwischen der Außenwand 64 und dem Innenring 66 ein Ringspalt 67 gebildet. Die radiale Breite des Ringspalts 67 entspricht zumindest der radialen Breite der Hohlzylinderwand 30 des Adapterkörpers 23 im Anschluss an deren freies Ende 33, also beim Ausführungsbeispiel entlang des äußeren Abschnitts 31b de Aufnahmeraums 31. Beim Aufschrauben des Verbindungsteils 63 auf die Hohlzylinderwand 30 kann ein sich an das freie Ende 33 anschließender Bereich der Hohlzylinderwand 30 in den Ringspalt 67 eingreifen.

Der Innenring 66 ist mit der Außenwand 64 des Verbindungsteils 63 über ein Querstück 68 verbunden. Das Querstück 68 hat eine ringförmige Gestalt und bildet beim Ausführungsbeispiel eine dem Adapterkörper 23 abgewandete obere Seite 69 des Verbindungsteils 63. Das Querstück 68, der Innenring 66 und der sich an das Querstück 68 anschließende axiale Teil der Außenwand 64 sind U-förmig zueinander angeordnet und begrenzen den Ringspalt 67.

Der Innendurchmesser des Innenrings 66 ist so groß gewählt, dass das Verbindungsteil 63 mit dem Innenring 66 um den ersten Träger 17 herum bzw. um einen Endabschnitt 17a des ersten Trägers 17 herum angeordnet werden kann. An diesem Endabschnitt 17a des ersten Trägers 17 befindet sich eine Hinterschneidung oder Trägernut 70. In diese Trägernut 70 kann nach dem Aufschieben des Verbindungsteils 63 auf den Endabschnitt 17a ein Halteteil 71 vorzugsweise rechtwinklig zur Axialrichtung A eingeschoben werden. Das Halteteil 71 ist insbesondere in Figur 4 veranschaulicht. Es ist beim Ausführungsbeispiel durch einen Haltebügel 72 gebildet, der zwei im Wesentlichen beispielsgemäß parallele Schenkel 73 aufweist, die über ein Zwischenstück 74 miteinander verbunden sind. Ist der Haltebügel 72 in die Trägernut 70 eingeschoben, ragt er zumindest abschnittsweise radial aus der Trägernut 70 heraus und bildet dort eine Angriffsfläche 75. Die Angriffsfläche 75 kann rechtwinklig oder schräg zur Axialrichtung A ausgerichtet sein. Sie befindet sich auf der axialen Seite des Haltebügels 72, die dem Verbindungsteil 63 zugewandt ist. Der maximale Abstand von vorzugsweise mehreren Bereichen des Halteteils 71 von einer Längsachse durch den Endabschnitt 17a des ersten Trägers 17 ist bei in die Trägernut 70 eingestecktem Halteteil größer als der Innenradius des Innenrings 66. Dadurch ist sichergestellt, dass die Stirnfläche 76 des Innenrings 66 an der Angriffsfläche 75 des Halteteils 71 angreifen kann. Das Halteteil 71 kann dadurch auch eine Verliersicherung für das Verbindungsteil 63 darstellen.

Das Halteteil 71 weist eine von der Kreisbogenform abweichende Innenkante auf, mit der es in der Trägernut 70 angeordnet ist. Auf diese Weise ist das Halteteil 71 bzw. der Haltebügel 72 nicht um die Axialrichtung A drehbar gegenüber dem Endabschnitt 17a des ersten Trägers 17.

In Abwandlung zum bevorzugten Ausführungsbeispiel sind auch andere Möglichkeiten zur Herstellung der lösbaren Verbindung zwischen dem Verbindungsteil 63 und dem Adapterkörper 23 realisierbar. Anstelle einer Schraubverbindung können auch Bajonettverbindungen, Rastverbindungen oder dergleichen verwendet werden. Die Schraubverbindung hat allerdings den Vorteil, dass die Haltekraft mit der der Innenring 66 auf die Angriffsfläche 75 des Halteteils 71 drückt, wenn das Verbindungsteil 63 auf den Adapterkörper 23 aufgeschraubt wird, sehr variabel eingestellt werden kann.

Das Halteteil 71 bildet bei dem hier beschriebenen Ausführungsbeispiel gemeinsam mit dem ersten Befestigungsabschnitt 26 bzw. der Hohlzylinderwand 30 ein Drehlagenvorgabemittel 80 (Figur 4). Das Drehlagenvorgabemittel 80 ist beim Ausführungsbeispiel dadurch gebildet, dass am Halteteil 71 ein sich radial von der Außenfläche bzw. der Außenkante des Halteteils 71 weg erstreckender Vorsprung 81 vorhanden ist. Der Vorsprung 81 erstreckt sich beim Ausführungsbeispiel in Axialrichtung A entlang der Außenkante des Halteteils 71. Bei der hier dargestellten Ausführungsform des Halteteils 71 in Form des Haltebügels 72 ist der Vorsprung 81 beispielsgemäß am Zwischenstück 74 angeordnet.

Auf der Innenseite der Hohlzylinderwand 30 ist eine sich ausgehend vom freien Ende 33 in Axialrichtung A erstreckende Aussparung 82 vorgesehen. Die Aussparung 82 erstreckt sich vorzugsweise bis zum Anschlag 32 entlang des äußeren Abschnitts 31b des Aufnahmeraums 31. Nach dem Einstecken des Halteteils 71 in die Trägernut 70 kann die Betätigungseinheit 15 mit dem Halteteil 71 lediglich in einer Drehlage um die Längsachse L mit dem Endabschnitt 17a und dem Halteteil 71 in den Aufnahmeraum 31 eingesteckt werden. Der Vorsprung 81 und die Aussparung 82 geben dabei eine eindeutige Drehlage vor. Dadurch ist sichergestellt, dass die Betätigungselemente 16 fluchtend zu den Adapterstößeln 38 angeordnet sind, um die Funktionsweise der Betätigungsvorrichtung 11 sicherzustellen.

Bei einem Ausführungsbeispiel, bei dem lediglich ein Adapterstößel 38 koaxial zur Längsachse L durch den Adapterkörper 23 vorhanden ist, kann ein Drehlagenvorgabemittel 80 entfallen.

Das Drehlagenvorgabemittel 80 kann auch durch andere Maßnahmen realisiert werden. Beispielsweise kann die Außenkante des Halteteils 71 eine von einem Kreis oder Kreisbogen abweichende Gestalt aufweisen, wobei die Innenfläche der Hohlzylinderwand 30 zumindest im äußeren Abschnitt 31b eine derart angepasst Kontur aufweist, so dass auch in diesem Fall lediglich eine vorgegebene Drehlage zum Einsetzen des Endabschnitts 17a mit dem Halteteil 71 in den Aufnahmeraum 31 möglich ist.

Mittels einer zweiten Befestigungseinrichtung 85 kann eine lösbare Verbindung zwischen dem zweiten Befestigungsabschnitt 27 des Adapterkörpers 23 und dem zweiten Träger 19 hergestellt werden. Bei dem hier dargestellten Ausführungsbeispiel wird diese lösbare Verbindung durch eine kraftschlüssige und/oder formschlüssige Verbindung hergestellt, im vorliegenden Fall durch eine Rastverbindung. Hierfür weist der Adapterkörper 23 im Befestigungsabschnitt 27 ein Rastmittel 86 auf, das mit einem Gegenrastmittel 87 am zweiten Träger 19 eine lösbare Rastverbindung herstellen kann. Als Rastmittel 86 können beispielsweise mehrere Rastnasen 88 dienen, die an entsprechenden Rastflächen der Gegenrastmittel 87 angreifen können, um die formschlüssige und/oder kraftschlüssige Verbindung herzustellen. Die zweite Befestigungseinrichtung 85 stellt die Ausrichtung des wenigstens einen Adapterstößels gegenüber dem zugeordneten Schaltelement 14 sicher.

Über die beiden Befestigungseinrichtungen 62, 85 kann somit eine lösbare Verbindung zwischen dem Adapterkörper 23, dem ersten Träger 17 der Betätigungseinheit 15 und dem zweiten Träger 19 der Schalteinheit 19 hergestellt werden. Bei hergestellter Verbindung sind der erste Träger 17, der Adapterkörper 23 und zweite Träger 19 in Axialrichtung A abgesehen von einem technisch notwendigen Montagespiel unbeweglich miteinander verbunden. Das wenigstens eine Betätigungselement 16 liegt mit seiner Betätigungsfläche 45 an der ersten Schaltfläche 44 des zugeordneten Adapterstößels 38 an bzw. dieser ersten Stößelfläche 44 mit geringem Axialabstand gegenüber. Gleichermaßen liegt in diesem montierten Zustand die Schalterfläche 57 an der zugeordneten zweiten Stößelfläche 57 an bzw. dieser mit geringem Axialabstand gegenüber. Der Adapterstößel 38 kann somit in Axialrichtung lediglich Druckkräfte vom Betätigungselement 16 zum Schaltelement 14 oder umgekehrt übertragen. Durch die lose Anlage der Stößelflächen 44, 56 an den zugeordneten Flächen 45, 57 ist eine Übertragung von Zugkräften nicht möglich. Die beiden Stößelflächen 44, 56 bilden somit jeweils eine Schnittstelle einerseits zum Betätigungselement 16 und andererseits zum Schaltelement 14 hin. Die Anlagestellen oder Anlageflächen, an denen die Stößelflächen 44, 56 an der jeweils zugeordneten Flächen 45, 57 des betreffenden Schaltelements 14 oder Betätigungselements 16 anliegen, stellen Trennstellen und beispielsgemäß Trennebenen dar. Beim hier beschriebenen Ausführungsbeispiel durchsetzt weder das Betätigungselement 16, noch das Schaltelement 14 die jeweils betreffende Trennebene. Somit sind sehr einfache Schnittstellen zwischen der Adaptereinrichtung 22 und der Betätigungseinheit 15 einerseits sowie der Adaptereinrichtung 22 und der Schalteinheit 14 anderseits gebildet.

Die Montage der Betätigungsvorrichtung 11 ist einfach und schnell durchführbar. Beim Ausführungsbeispiel wird die Betätigungsvorrichtung 11 wie folgt montiert:
Als erstes kann zum Beispiel die Adaptereinrichtung 22 mit dem Adapterkörper 23 in der Gehäuseöffnung 24 angeordnet werden, beispielsweise durch Einschrauben des Adapterkörpers 23 mit dem Außengewinde 25 in ein entsprechendes Innengewinde der Gehäuseöffnung 24. Dabei wird vorzugsweise die Aussparung 82 in der gewünschten Drehposition um die Längsachse L des Adapterkörpers 23 ausgerichtet, zumindest dann, wenn die Betätigungseinheit 15 einen Drehschalter oder Drehtaster 18b aufweist.

Vorher oder anschließend kann das Verbindungsteil 63 mit dem Innenring 66 über den Endabschnitt 17a gesteckt und durch anschließendes Einschieben des Haltebügels 72 in die Trägernut 70 gegen eine Bewegung in Axialrichtung A zumindest zu einer Seite hin gesichert werden.

Im Anschluss daran werden die Betätigungseinheit 15 mit Hilfe der ersten Befestigungseinrichtung 62 und die Schalteinheit 13 mit Hilfe der zweiten Befestigungseinrichtung 85 jeweils lösbar mit dem Adapterkörper 23 verbunden. Das Anbringen der Schalteinheit 13 erfolgt erst, wenn der Adapterkörper 23 in der Gehäuseöffnung 24 befestigt wurde, wohingegen die Betätigungseinheit 15 auch schon vorher an dem Adapterkörper 23 angebracht werden kann. Die Betätigungseinheit 15 ist außen am Gehäuse 10 und die Schalteinheit 13 im Innenraum 12 des Gehäuses 10 gehalten.

In der Ruhelage ist der wenigstens eine Adapterstößel 38 durch die Feder 50 zum zugeordneten Betätigungselement 16 hin vorgespannt. Wir das Betätigungselement 16 in Axialrichtung A gegen das erste Ende 42 des Adapterstößels 38 bewegt, so wird der Adapterstößel 38 in dem Adapterkanal 39 entsprechend der Bewegung des Betätigungselements 16 in Axialrichtung A verschoben. Dabei bewegt der Adapterstößel 38 durch Kontakt des axialen zweiten Endes 43 mit dem zugeordneten Schalterfläche 57 auch das Schaltelement 14 in Axialrichtung A. Dadurch kann beispielsweise wenigstens ein dem Schaltelement 14 zugeordneter elektrischer Kontakt umgeschaltet, also geschlossen oder geöffnet werden.

Die Erfindung betrifft eine Befestigungsvorrichtung 11 für ein explosionsgeschütztes Gehäuse 10 in der Zündschutzart "druckfeste Kapselung". Die Betätigungsvorrichtung 11 weist eine Betätigungseinheit 15 mit einem manuell betätigbaren Betätigungselement 16 auf. Das Betätigungselement 16 ist in einer Axialrichtung A bewegbar. Die Betätigungsvorrichtung 11 weist außerdem eine Schalteinheit 14 mit wenigstens einem Schaltelement 14 zum Umschalten wenigstens eines zugeordneten elektrischen Kontakts auf. Die Betätigungseinheit 15 befindet sich außerhalb des Gehäuses 10, während die Schalteinheit 13 im Innenraum 12 des Gehäuses 10 angeordnet ist. Eine Adaptereinrichtung 22 verbindet die Betätigungseinheit 15 und die Schalteinheit 13 mechanisch und weist wenigstens einen in Axialrichtung A verschiebbar gelagerten Adapterstößel 38 auf, um die Bewegung des Betätigungselements 16 über den Adapterstößel 38 auf das wenigstens eine Schaltelement 14 zu übertragen. Der Adapterstößel 38 ist in einem Adapterkanal 39 axial verschiebbar unter Bildung eines zünddurchschlagsicheren Spalts 53 angeordnet.

### Bezugszeichenliste:

- 10: Gehäuse
- 11: Betätigungsvorrichtung
- 12: Innenraum
- 13: Schalteinheit
- 14: Schaltelement
- 15: Betätigungseinheit
- 16: Betätigungselement
- 17: erster Träger
- 17a: Endabschnitt des ersten Trägers
- 18a: Druckschalter oder Drucktaster
- 18b: Drehschalter oder Drehtaster
- 19: zweiter Träger

- 22: Adaptereinrichtung
- 23: Adapterkörper
- 24: Gehäusesöffnung
- 25: explosionsgeschütztes Außengewinde
- 26: erster Befestigungsabschnitt
- 27: zweiter Befestigungsabschnitt
- 28: Mittelabschnitt
- 29: Ringstufe
- 30: Hohlzylinderwand
- 31: Aufnahmeraum
- 31a: innerer Abschnitt
- 31b: äußerer Abschnitt
- 32: Anschlag
- 33: freies Ende der Hohlzylinderwand
- 34: Ringvorsprung

- 38: Adapterstößel
- 39: Adapterkanal
- 40: erste Mündung
- 41: zweite Mündung
- 42: axiales erstes Ende
- 43: axiales zweites Ende
- 44: erste Stößelfläche
- 45: Betätigungsfläche

- 48: Ringnut
- 49: Sicherungsring
- 50: Feder
- 51: Ringschulter
- 52: Axialabschnitt
- 53: zünddurchschlagsicherer Spalt
- 54: Dichtungsnut
- 55: Endstück
- 56: zweite Stößelfläche
- 57: Dichtung

- 62: erste Befestigungseinrichtung
- 63: Verbindungsteil
- 64: Außenwand des Verbindungsteils
- 65: Innengewinde
- 66: Innenring
- 67: Ringspalt
- 68: Querstück
- 69: obere Seite des Verbindungsteils
- 70: Trägernut
- 71: Halteteil
- 72: Haltebügel
- 73: Schenkel
- 74: Zwischenstück
- 75: Angriffsfläche
- 76: Stirnfläche des Innenrings

- 80: Drehlagenvorgabemittel
- 81: Vorsprung
- 82: Aussparung

- 85: zweite Befestigungseinrichtung
- 86: Rastmittel
- 87: Gegenrastmittel
- 88: Rastnase

- A: Axialrichtung
- L: Längsachse

## Patentansprüche

1. Betätigungsvorrichtung (11) für ein explosionsgeschütztes Gehäuse (10), aufweisend eine Betätigungseinheit (15), eine Schalteinheit (13) und eine Adaptereinrichtung (22),
wobei die Betätigungseinheit (15) einen ersten Träger (17) aufweist,
mit wenigstens einem relativ zum ersten Träger (17) bewegbaren Betätigungselement (16),
wobei die Schalteinheit (13) einen zweiten Träger (19) aufweist
mit wenigstens einem relativ zum zweiten Träger (19) bewegbaren Schaltelement (14),
wobei die Adaptereinrichtung (22) einen Adapterkörper (23) aufweist, der sich in Axialrichtung (A) erstreckt, wobei der Adapterkörper (23) an einem axialen Ende einen ersten Befestigungsabschnitt (26) und am anderen axialen Ende einen zweiten Befestigungsabschnitt (27) aufweist,
wobei die Adaptereinrichtung (22) wenigstens einen Adapterstößel (38) aufweist, der in einem im Adapterkörper (23) in Axialrichtung (A) verlaufenden Adapterkanal (39) verschiebbar gelagert ist, wobei zumindest in einem Axialabschnitt (52) ein zünddurchschlagsicherer Spalt (53) zwischen dem Adapterstößel (38) und dem Adapterkanal (39) gebildet ist,
wobei das axiale erste Ende (42) jedes Adapterstößels (38) dem wenigstens einen Betätigungselement (16) zugeordnet ist, wobei das axiale zweite Ende (43) jedes Adapterstößels (38) jeweils einem Schaltelement (14) der Schalteinheit (13) zugeordnet ist,
**dadurch gekennzeichnet, dass**
das Betätigungselement (16) relativ zum ersten Träger (17) und das Schaltelement (14) relativ zum zweiten Träger (19) jeweils in Axialrichtung (A) bewegbar ist, und dass der erste Befestigungsabschnitt (26) derart lösbar mit dem ersten Träger (17) der Betätigungseinheit (15) und der zweite Befestigungsabschnitt (27) derart lösbar mit dem zweiten Träger (19) der Schalteinheit (13) verbunden sind, dass die beiden Träger (17, 19) und der Adapterkörper (23) im verbundenen Zustand unbeweglich aneinander gelagert sind.

2. Betätigungsvorrichtung nach Anspruch 1,
**dadurch gekennzeichnet, dass** der wenigstens eine Adapterstößel (38) an seinem axialen ersten Ende (42) eine erste Stößelfläche (44) aufweist, die an dem zugeordneten Betätigungselement (16) anliegt oder diesem in Axialrichtung (A) mit Abstand gegenüberliegt.

3. Betätigungsvorrichtung nach Anspruch 1 oder 2,
**dadurch gekennzeichnet, dass** der wenigstens eine Adapterstößel (38) an seinem axialen zweiten Ende (43) eine zweite Stößelfläche (56) aufweist, die an einem zugeordneten Schaltelement (14) anliegt oder diesem in Axialrichtung (A) mit Abstand gegenüberliegt.

4. Betätigungsvorrichtung nach einem der vorhergehenden Ansprüche,
**dadurch gekennzeichnet, dass** die Adaptereinrichtung (22) eine erste Befestigungseinrichtung (62) aufweist, mittels der der erste Befestigungsabschnitt (26) des Adapterkörpers (23) mit der Betätigungseinheit (15) lösbar verbunden ist und/oder dass die Adaptereinrichtung (22) eine zweite Befestigungseinrichtung (85) aufweist, mittels der der zweite Befestigungsabschnitt (27) des Adapterkörpers (23) mit der Schalteinheit (13) lösbar verbunden ist.

5. Betätigungsvorrichtung nach Anspruch 4,
**dadurch gekennzeichnet, dass** die erste Befestigungseinrichtung (62) ein an der Betätigungseinheit (15) angeordnetes Verbindungsteil (63) aufweist, das formschlüssig und/oder kraftschlüssig lösbar mit dem ersten Befestigungsabschnitt (26) verbunden ist.

6. Betätigungsvorrichtung nach Anspruch 5,
**dadurch gekennzeichnet, dass** das Verbindungsteil (63) durch ein Halteteil (71) lösbar mit der Betätigungseinheit (15) verbunden ist.

7. Betätigungsvorrichtung nach Anspruch 6,
**dadurch gekennzeichnet, dass** das Halteteil (71) formschlüssig in eine Aussparung (70) an der Betätigungseinheit (15) eingreift und eine Angriffsfläche (75) für das Verbindungsteil (63) bereitstellt.

8. Betätigungsvorrichtung nach Anspruch 5 oder 6,
**dadurch gekennzeichnet, dass** das Halteteil (71) zumindest an einer Stelle mit dem ersten Befestigungsabschnitt (26) des Adapterkörpers (23) in Kontakt ist und das Halteteil (71) gemeinsam mit dem ersten Befestigungsabschnitt (26) ein Drehlagenvorgabemittel (80) bildet, das die Relativdrehlage um die Axialrichtung (A) zwischen der Betätigungseinheit (15) und/oder dem ersten Träger (17) und dem Adapterkörper (23) vorgibt.

9. Betätigungsvorrichtung nach einem der vorhergehenden Ansprüche,
**dadurch gekennzeichnet, dass** der erste Befestigungsabschnitt (26) hohlzylindrisch ausgeführt ist.

10. Betätigungsvorrichtung nach einem der vorhergehenden Ansprüche,
**dadurch gekennzeichnet, dass** der Adapterkörper (23) einen Mittelabschnitt (28) mit einer zylindrischen Außenkontur aufweist, der von dem wenigstens einen Adapterkanal (39) durchsetzt wird.

11. Betätigungsvorrichtung nach Anspruch 10,
**dadurch gekennzeichnet, dass** der Mittelabschnitt (28) die beiden Befestigungsabschnitte (26, 27) verbindet.

12. Betätigungsvorrichtung nach einem der vorhergehenden Ansprüche,
**dadurch gekennzeichnet, dass** die Betätigungseinheit (15) und/oder die Schalteinheit (13) ohne besondere Zündschutzmaßnahmen ausgeführt ist.

13. Gehäuse (10) mit einer Betätigungsvorrichtung (11) nach einem der vorhergehenden Ansprüche,
wobei die Betätigungseinheit an der Außenseite des Gehäuses (10) angeordnet ist,
wobei die Schalteinheit (13) im Innenraum (12) des Gehäuses (10) angeordnet ist,
und wobei der Adaptereinrichtung (22) explosionsgeschützt durch die Gehäusewand geführt ist.

14. Gehäuse nach Anspruch 13,
**dadurch gekennzeichnet, dass** das Gehäuse (10) in der Zündschutzart "druckfeste Kapselung" ausgeführt ist.

15. Gehäuse nach Anspruch 13 oder 14,
**dadurch gekennzeichnet, dass** zwischen dem Adapterkörper (23) und der Gehäusewand ein zünddurchschlagsicherer Spalt vorhanden ist.

## Claims

1. Actuation device (11) for an explosion-proof housing (10), having an actuation unit (15), a switch unit (13) and an adapter device (22),
wherein the actuation unit (15) comprises a first carrier (17) with at least one actuation element (16) which can be moved relative to the first carrier (17),
wherein the switch unit (13) comprises a second carrier (19) with at least one switch element (14) which is movable relative to the second carrier (19),
wherein the adapter device (22) comprises an adapter body (23) extending in the axial direction (A), wherein the adapter body (23) comprises a first fixing portion (26) at one axial end and a second fixing portion (27) at the other axial end,
wherein the adapter device (22) comprises at least one adapter ram (28) which is mounted movably in an adapter channel (39) running in the axial direction (A) in the adapter body (23), wherein at least in an axial portion (52), a gap (53) secure against ignition discharge is formed between the adapter ram (38) and the adapter channel (39),
wherein the first axial end (42) of each adapter ram (38) is assigned to the at least one actuating element (16), wherein the second axial end (43) of each adapter ram (38) is assigned to a respective switch element (14) of the switch unit (13),
**characterized in that**
the actuation element (16) is movable relative to the first carrier (17) and the switch element (14) is movable relative to the second carrier (19) each in the axial direction (A),
and that the first fixing portion (26) is connected detachably to the first carrier (17) of the actuation unit (15) and the second fixing portion (27) is connected detachably to the second carrier (19) of the switch unit (13), in each case such that the two carriers (17, 19) and the adapter body (23) are mounted immovably relative to each other in connected state.

2. Actuation device according to claim 1, **characterized in that** the at least one adapter ram (38) on its first axial end (42) has a first ram face (44) which lies on the assigned actuating element (16) or opposite this with a spacing in the axial direction (A).

3. Actuation device according to claim 1 or 2, **characterized in that** the at least one adapter ram (38) at its second axial end (43) has a second ram face (56) which lies on an assigned switch element (14) or opposite this with a spacing in the axial direction (A).

4. Actuation device according to any of the preceding claims, **characterized in that** the adapter device (22) has a first fixing device (62), by means of which the first fixing portion (26) of the adapter body (23) is detachably connected to the actuation unit (15), and/or that the adapter device (22) has a second fixing device (85) by means of which the second fixing portion (27) of the adapter body (23) is detachably connected to the switch unit (13).

5. Actuation device according to claim 4, **characterized in that** the first fixing device (62) comprises a connecting part (63) which is arranged on the actuation unit (15) and is connected detachably to the first fixing portion (26) by form fit and/or by force fit.

6. Actuation device according to claim 5, **characterized in that** the connecting part (63) is connected detachably to the actuation unit (15) by means of a bracket (71).

7. Actuation device according to claim 6, **characterized in that** the bracket (71) engages by form fit in a recess (70) on the actuation unit (15) and provides a contact face (75) for the connecting part (63).

8. Actuation device according to claim 5 or 6, **characterized in that** the bracket (71) at least at one point is in contact with the first fixing portion (26) of the adapter body (23), and the bracket (71) together with the first fixing portion (26) forms a means (80) for predefining rotary positions, which defines the relative rotary position about the axial direction (A) between the actuation unit (15) and/or the first carrier (17) and the adapter body (23).

9. Actuation device according to any of the preceding claims, **characterized in that** the first fixing portion (26) is configured hollow cylindrical.

10. Actuation device according to any of the preceding claims, **characterized in that** the adapter body (23) has a middle portion (28) with a cylindrical outer contour, through which the at least one adapter channel (39) passes.

11. Actuation device according to claim 10, **characterized in that** the middle portion (28) connects the two fixing portions (26, 27).

12. Actuation device according to any of the preceding claims, **characterized in that** the actuation unit (15) and/or the switch unit (13) are configured without particular ignition-protection measures.

13. Housing (10) with actuation device (11) according to any of the preceding claims, wherein the actuation unit is arranged on the outside of the housing (10),
wherein the switch unit (13) is arranged in the interior (12) of the housing (10),
and wherein the adapter device (22) is guided in explosion-proof fashion through the housing wall.

14. Housing according to claim 13, **characterized in that** the housing (10) is produced with "pressure-resistant encapsulation" ignition protection.

15. Housing according to claim 13 or 14, **characterized in that** a gap secure against ignition discharge is present between the adapter body (23) and the housing wall.

## Revendications

1. Dispositif d'actionnement (11) destiné à un boîtier antidé-flagrant (10), présentant une unité d'actionnement (15), une unité de commutation (13) et un dispositif adaptateur (22),
dans lequel l'unité d'actionnement (15) présente un premier support (17),
avec au moins un élément d'actionnement (16) pouvant être déplacé par rapport au premier support (17),
dans lequel l'unité de commutation (13) présente un deuxième support (19),
avec au moins un élément de commutation (14) pouvant être déplacé par rapport au deuxième support (19),
dans lequel le dispositif adaptateur (22) présente un corps adaptateur (23) qui s'étend dans la direction axiale (A), le corps adaptateur (23) présentant une première partie de fixation (26) à une extrémité axiale et une deuxième partie de fixation (27) à l'autre extrémité axiale,
dans lequel le dispositif adaptateur (22) présente au moins un poussoir d'adaptateur (38) qui est monté avec possibilité de déplacement dans un canal d'adaptateur (39) s'étendant dans la direction axiale (A) dans le corps d'adaptateur (23), un joint antidéflagrant (53) entre le poussoir d'adaptateur (38) et le canal d'adaptateur (39) étant formé au moins dans une portion axiale (52),
dans lequel la première extrémité axiale (42) de chaque poussoir d'adaptateur (38) est associée à l'élément d'actionnement (16), au nombre d'au moins un, la deuxième extrémité axiale (43) de chaque poussoir d'adaptateur (38) étant associée respectivement à un élément de commutation (14) de l'unité de commutation (13),
**caractérisé en ce que**
l'élément d'actionnement (16) peut être déplacé par rapport au premier support (17) et l'élément de commutation (14) peut être déplacé par rapport au deuxième support (19), chaque fois dans la direction axiale (A),
et **en ce que** la première partie de fixation (26) est reliée de façon amovible au premier support (17) de l'unité d'actionnement (15) et la deuxième partie de fixation (27) est reliée de façon amovible au deuxième support (19) de l'unité de commutation (13), de telle manière qu'à l'état relié, les deux supports (17, 19) et le corps adaptateur (23) soient en appui immobile les contre les autres.

2. Dispositif d'actionnement selon la revendication 1, **caractérisé en ce que** le poussoir d'adaptateur (38), au nombre d'au moins un, présente, sur sa première extrémité axiale (42), une première surface de poussoir (44) qui est appliquée contre l'élément d'actionnement (16) associé ou se trouve en vis-à-vis et à distance de celui-ci dans la direction axiale (A).

3. Dispositif d'actionnement selon la revendication 1 ou 2, **caractérisé en ce que** le poussoir d'adaptateur (38), au nombre d'au moins un, présente, sur sa deuxième extrémité axiale (43), une deuxième surface de poussoir (56) qui est appliquée contre un élément de commutation (14) associé ou se trouve en vis-à-vis et à distance de celui-ci dans la direction axiale (A).

4. Dispositif d'actionnement selon l'une des revendications précédentes, **caractérisé en ce que** le dispositif adaptateur (22) présente un premier dispositif de fixation (62) au moyen duquel la première partie de fixation (26) du corps adaptateur (23) est reliée de façon amovible à l'unité d'actionnement (15), et/ou **en ce que** le dispositif adaptateur (22) présente un deuxième dispositif de fixation (85) au moyen duquel la deuxième partie de fixation (27) du corps adaptateur (23) est reliée de façon amovible à l'unité de commutation (13).

5. Dispositif d'actionnement selon la revendication 4, **caractérisé en ce que** le premier dispositif de fixation (62) présente une pièce de liaison (63) qui est disposée sur l'unité d'actionnement (15) et est reliée par complémentarité de formes et/ou par adhérence de façon amovible à la première partie de fixation (26).

6. Dispositif d'actionnement selon la revendication 5, **caractérisé en ce que** la pièce de liaison (63) est reliée de façon amovible à l'unité d'actionnement (15) par un élément de maintien (71).

7. Dispositif d'actionnement selon la revendication 6, **caractérisé en ce que** l'élément de maintien (71) s'engage par complémentarité de formes dans un évidement (70) de l'unité d'actionnement (15) et fournit une surface de prise (75) pour la pièce de liaison (63).

8. Dispositif d'actionnement selon la revendication 5 ou 6, **caractérisé en ce que** l'élément de maintien (71) est en contact à au moins un endroit avec la première partie de fixation (26) du corps adaptateur (23), et que l'élément de maintien (71) forme avec la première partie de fixation (26) un moyen de consigne de position angulaire (80) qui prédéfinit la position angulaire relative autour de la direction axiale (A) entre l'unité d'actionnement (15) et/ou le premier support (17) et le corps adaptateur (23).

9. Dispositif d'actionnement selon l'une des revendications précédentes, **caractérisé en ce que** la première partie de fixation (26) est réalisée sous une forme cylindrique creuse.

10. Dispositif d'actionnement selon l'une des revendications précédentes, **caractérisé en ce que** le corps adaptateur (23) présente une partie médiane (28) avec un contour extérieur cylindrique, qui est traversée par le canal d'adaptateur (39), au nombre d'au moins un.

11. Dispositif d'actionnement selon la revendication 10, **caractérisé en ce que** la partie médiane (28) relie les deux parties de fixation (26, 27).

12. Dispositif d'actionnement selon l'une des revendications précédentes, **caractérisé en ce que** l'unité d'actionnement (15) et/ou l'unité de commutation (13) sont réalisées sans mesures antidéflagrantes particulières.

13. Boîtier (10) doté d'un dispositif d'actionnement (11) selon l'une des revendications précédentes,
dans lequel l'unité d'actionnement est disposée sur la face externe du boîtier (10),
dans lequel l'unité de commutation (13) est disposée dans l'espace intérieur (12) du boîtier (10),
et dans lequel le dispositif adaptateur (22) est guidé de façon antidéflagrante à travers la paroi de boîtier.

14. Boîtier selon la revendication 13, **caractérisé en ce que** le boîtier (10) est réalisé avec la protection "blindage antidéflagrant".

15. Boîtier selon la revendication 13 ou 14, **caractérisé en ce qu'**un joint antidéflagrant est prévu entre le corps adaptateur (23) et la paroi de boîtier.
